# EUROPEAN PATENT SPECIFICATION

(11) **EP 0 769 833 B1**
(45) Date of publication and mention of the grant of the patent: **09.06.1999**
(21) Application number: 96115757.5
(22) Date of filing: 02.10.1996
(51) Int. Cl.: H02B 1/46, H05K 5/02

(54) **Power supply box**
Stromversorgungsgehäuse
Boîtier d'alimentation électrique

(30) Priority: 17.10.1995 JP 26821795
(43) Date of publication of application: 23.04.1997
(73) Proprietor: MATSUSHITA ELECTRIC INDUSTRIAL CO., LTD., Kadoma-shi, Osaka 571-0050 (JP)
(72) Inventor: Isemura, Nobuhisa, Otsu-shi, Shiga, 520-22 (JP); Kido, Kouichi, Otsu-shi, Shiga, 520-22 (JP); Nakanuma, Mitsuo, Hino-cho, Gamou-gun, Shiga, 529-16 (JP)
(74) Representative: Kügele, Bernhard

(56) References cited:
- DE-U- 7 138 560
- GB-A- 2 238 915
- PATENT ABSTRACTS OF JAPAN vol. 15, no. 283 (M-1137), 18 July 1991 & JP 03 099131 A (MATSUSHITA ELECTRIC IND CO LTD), 24 April 1991,

## Description

### BACKGROUND OF THE INVENTION

The present invention relates to a power supply box, and more particularly to a power supply box accommodating a connection unit and a power supply unit.

Hitherto, in the power supply box for connecting an indoor unit and an outdoor unit of an air-conditioner, the power supply box having different types of terminals suited to the standard of individual nation or model has been manufactured. Or, so as to be applicable to terminals of several different standards, the power supply box allowing to connect with any one of plural types of terminals has been manufactured.

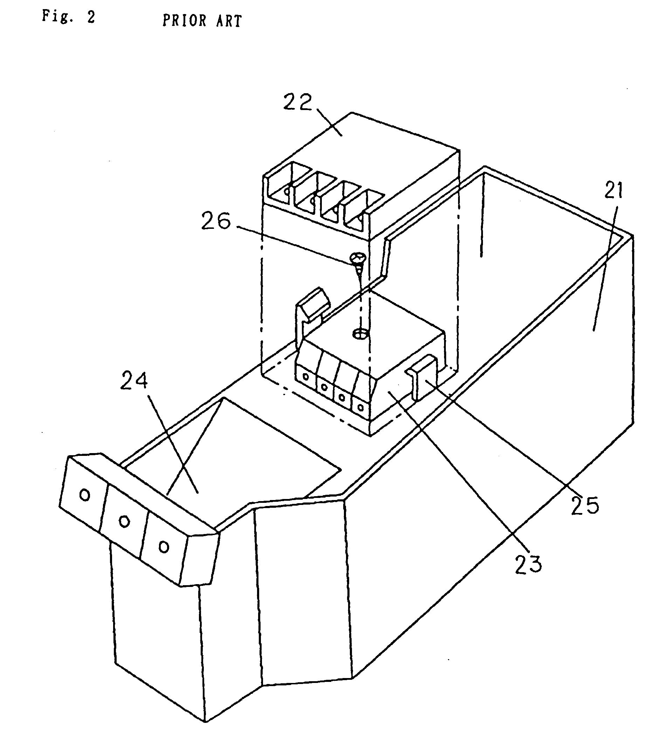

A structural drawing of a conventional example of a power supply box capable of installing one of two terminals is shown in Fig. 2. The power supply box in Fig. 2 is applied when using either large terminal of one standard or small terminal of other standard. In Fig. 2, the power supply box is composed of a container case 21, a power supply unit (not shown) installed at a specific position of the container case 21, and a larger terminal 22 or small terminal 23 installed at a specific position of the container case 21. The container case 21 has a fixing rib 25 matching with the shape of the large terminal 22, and when connecting the large terminal 22, the large terminal 22 is fixed in the container case 21 through the rib 25. When installing the small terminal 23, the small terminal 23 is fixed by a screw 26.

The power supply unit comprises, for example, a printed circuit board, an integrated circuit, and various electronic components. The large terminal 22 or small terminal 23 is connected to the power supply unit provided in the container case 21. In such constitution, a power cable is connected to the large terminal 22 or small terminal 23 through a power cable inlet 24.

In this constitution, when installing the small terminal 23, fixing job by the screw 26 was needed. Therefore, when manufacturing the small terminal, a drilling process for passing the screw was needed. Moreover, when installing the small terminal, it needed the expense for the fixing work by the screw.

On the other hand, where individual works for two kinds of terminals were not allowed, two power supply boxes suited to the individual works were needed. In this case, power supply boxes conforming to two types of standards are necessary. It therefore caused to increase the die expenses for manufacturing the container cases, increase the material cost, and increase the number of parts. As a result, the manufacturing cost was raised. Thus, the conventional power supply box was expensive owing to increase in the expenses for work, variety of parts, die expenses, and material cost.

It is hence an object of the invention to solve the problems of the prior art and present a power supply box having effects such as excellent working efficiency, low die expense, and low material cost.

### SUMMARY OF THE INVENTION

The power supply box of the invention is used for completing one apparatus by connecting plural devices by the use of a connection power cable. The power supply box of the invention comprises (1) a container case having an inlet for inserting the connection power cable, (2) a power supply unit installed at a first position of the container case, (3) a terminal installed at a second position of the container case, for mutually connecting the plural devices, and (4) fixing means for fixing the terminal to the container case. According to the features of the power supply box of the invention, in this power supply box, the terminal is only one of first terminal and second terminal, the length of the first terminal in X direction is longer than the length of the second terminal in X direction, the fixing means possesses a first rib for fixing the first terminal installed integrally in the container case, and a second rib for fixing the second terminal, the end portion of the first terminal or second terminal in X direction is fitted and fixed to the first rib or the second rib, the inlet, the first rib, and the second rib are arranged nearly in series in Y direction orthogonal to the X direction, the first rib is installed closer to the inlet than the second rib, and only one of the first terminal and the second terminal is fixed in the container case.

In this constitution, preferably, the one apparatus is an air-conditioner, and the plural devices are an outdoor unit and an indoor unit.

In this constitution, preferably, the second rib is positioned outside of the width of the second terminal in X direction, in a side view as seen from the inlet, when the second terminal is fixed in the second rib.

In this constitution, preferably, the first terminal and the second terminal are nearly in a form of rectangular parallelepiped, the first rib has at least two ribs confronting each other, and the mutually confronting end portions of the first terminal are fitted and fixed in the two ribs.

In this constitution, preferably, the first terminal and the second terminal are nearly in a form of rectangular parallelepiped, the second rib has at least two ribs confronting each other, and the mutually confronting end portions of the second terminal are fitted and fixed in the two ribs.

According to the constitution, in the power supply box commonly used in plural devices having terminals of different standards or types, post-process work such as fixing with screw or processing is not needed, and the job working efficiency is enhanced extremely. Moreover, when the small terminal small in the length in X direction is installed at a position remote from the inlet, the fixing rib formed for installing the large terminal large in the length in X direction does not interfere the connection work of the connection power cable, so that the connection work of the small terminal and connection power cable is extremely smooth and easy. In particular, when connecting the connection power cable composed of a single wire poor in flexibility to the small terminal, the working space can be widely kept, and the connection work is extremely easy.

Being commonly usable in plural devices having terminals differing in the standard or type, it is not necessary to manufacture plural power supply boxes, and it is advantageous in the aspect of die expense and material cost.

### BRIEF DESCRIPTION OF THE DRAWINGS

Fig. 1 is a perspective view of a power supply box in an embodiment of the invention.

Fig. 2 is a perspective view of a power supply box in a prior art.

### REFERENCE NUMERALS

- 1: Power supply box
- 2: First terminal (large terminal, terminal for stranded wires)
- 3: Second terminal (small terminal, terminal for a single wire)
- 3a: Connection unit of small terminal
- 4: Inlet of connection power cable
- 5: First fixing rib
- 7: Connection power cable
- 8: Second fixing rib
- 21: Container case
- 22: Large terminal
- 23: Small terminal
- 25: Fixing rib
- 26: Fixing screw

### DESCRIPTION OF THE PREFERRED EMBODIMENT

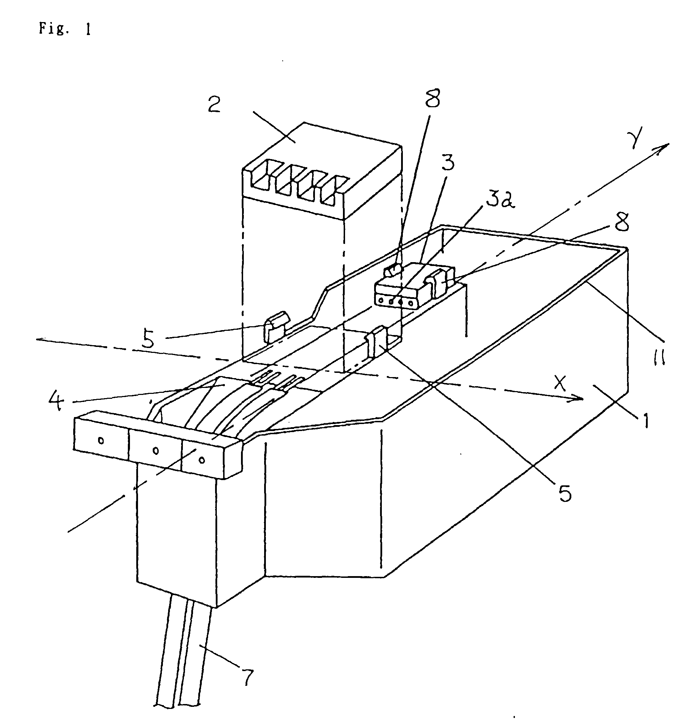

As a preferred embodiment of the power supply box of the invention, the power supply box for connecting an indoor unit and an outdoor unit of an air-conditioner is described below by reference to Fig. 1. Fig. 1 is a perspective view of a power supply box in an embodiment of the invention. In Fig. 1, a power supply box 1 is composed of a container case 11, a large terminal 2 as a first terminal installed at a first position of the container case 11, and a power supply unit (not shown) installed at other position of the container case 11. Instead of the large terminal 2, alternatively, a small terminal 3 may be installed. The large terminal and small terminal are nearly of rectangular parallelepiped. The length of the large terminal in X direction is longer than the length of small terminal in X direction. The small terminal 3 has plural connection units 3a for connecting a connection power cable 7 at its one side surface. The container case 11 has a first fixing rib 5 matched with the shape of the large terminal 2, and a second fixing rib 8 matched with the shape of the small terminal 3. The first fixing rib 5 has a pair of ribs at mutually confronting positions for fixing confronting sides of the large terminal 2. Similarly, the second fixing rib 8 has a pair of ribs at mutually confronting positions for fixing confronting sides of the small terminal 3. The container case 11 has the inlet 4 for inserting the connection power cable 7. The first fixing rib 5 for fixing the large terminal 2 is installed at a position close to the inlet 4, and the second fixing rib 8 for fixing the small terminal 3 is installed at a position remote from the inlet 4.

When installing the large terminal 2, the large terminal 2 is fixed in the container case 11 by the first fixing rib 5. When installing the small terminal 3, the small terminal 3 is fixed in the container case 11 by the second fixing rib 8.

The installing position of the inlet 4 and large terminal 5 and the installing position of the small terminal 3 are designed to be arranged nearly in series in Y direction orthogonal to X direction. The distance between the pair of ribs of the first fixing rib 5 is designed to be larger than the width outer dimension of the small terminal 3. That is, when the small terminal 3 is installed in the second fixing rib 8, the first fixing rib 5 is positioned outside of the width of the small terminal 3 in X direction, in a side view as seen from the inlet 4.

The first fixing rib 5 and second fixing rib 8 are manufactured, for example, by resin molding integrally with the container case 11. The shape of the first fixing rib 5 and second fixing rib 8 is not particularly limited, but it is preferred to be shaped so as to be fixed without resort to any auxiliary tool or part. The shape of the fixing rib is, preferably, a protruding shape having a pawl, a deformable protruding shape, or an elastic protruding shape like a spring. By the elastic force of the pawl or spring function, the large terminal 2 or small terminal 3 is fixed in the container case 11.

The power supply unit comprises, for example, a printed wiring board, an integrated circuit, and various electronic components, and is installed, for instance, at a second position of the container case 11. A first position of the container case is at the upper side of a middle plate (not shown) formed in the container case 11, and the second position is at the lower side of this middle plate.

The large terminal 2 or small terminal 3 is electrically connected to the power supply unit accommodated in the container case 11.

In such constitution, the connection power cable 7 is connected to the large terminal 2 or small terminal 3 through the inlet 4 of the connection power cable 7.

When the small terminal 3 is installed, the connection unit 3a of the small terminal 3 is positioned inside of the pair of ribs of the first fixing rib 5 in a side view as seen from the inlet 4. That is, in the side view, the positions of the pair of ribs of the first fixing rib 5 are located outside of the width dimension of the small terminal 3. Therefore, by installing the small terminal 3 and inserting the connection power cable 7 from the inlet 4, when connecting the small terminal 3 and connection power cable 7, the pair of ribs of the first fixing rib 5 will not interfere, and only by inserting the connection power cable 7 from the inlet 4, it can be easily connected with the connection unit 3a of the small terminal 3. As a result, the connection work of the connection power cable 7 and small terminal 3 is extremely facilitated.

Due to difference in the national standard or type of apparatus, the connection power cable 7 may be either single wire connection power cable composed of a single wire or a stranded wire power cable composed of a set of plural stranded wires. The single wire power cable is relatively hard to bend and is poor in flexibility, and therefore the terminal for connecting such single wire power cable is preferred to be installed at a position remote from the inlet 4. That is, the small terminal 3 is preferred to be a terminal for connecting the single wire connection power cable. In such constitution, in the working procedure of connecting the connection power cable 7 composed of a single wire to the connection unit 3a of the small terminal 3, the working space is sufficiently held, and the connection work is extremely facilitated.

As described herein, in the power supply box commonly usable in plural devices having terminals of different standards or types, in the constitution of the invention, post-process work such as fixing with screw or processing is not needed, and the working efficiency is notably enhanced.

Moreover, when the small terminal positioned at a distance remote from the inlet is installed, the fixing rib formed for installing the large terminal does not interfere the connection work of the connection power cable, and therefore the connection work of the small terminal and connection power cable is extremely easy. In particular, the connection work is very easy when connecting the connection power cable composed of a single wire poor in flexibility with the small terminal.

The power supply box of the invention can be commonly used in plural devices having terminals differing in standard or type, and it is not necessary to manufacture plural power supply boxes, so that the die expenses and material cost may be saved.

The power supply box of the invention is particularly preferable in the application of an air-conditioner comprising an indoor unit and an outdoor unit. Instead of the air-conditioner, however, it may be also applied to one apparatus completed by connecting plural devices, or other apparatus having terminals differing in standard or type.

For example, in one apparatus completed by connecting three devices, a desired number of connection units 3a may be designed.

Alternatively, a power supply box sharing terminals of different sizes may be also applicable. For example, in the case of the power supply box sharing terminals of three different sizes, that is, large terminal, medium terminal, and small terminal, a third fixing rib for fixing the middle terminal may be disposed between the first fixing rib and second fixing rib.

Instead of the first fixing rib and second fixing rib, yet, plural fixing ribs may be disposed. In this constitution, each rib of the plural fixing ribs may connect only one of the plural terminals mutually different in width. That is, the terminal having the greatest width of the plural terminals is fixed to the position closest to the inlet, the terminal having the smallest width is fixed to the position remotest from the inlet, and in this way the individual fixing ribs of the plural fixing ribs are installed so that the terminals having smaller width can be fixed as going remoter from the inlet.

In this constitution, the first fixing rib and second fixing rib can be manufactured from resin molding integrally with the container case. In this case, the manufacturing cost is extremely lowered.

The container case and the fixing ribs may be also manufactured from resin molding by inserting metal elements. In this case, the container case and fixing ribs having desired properties can be manufactured at lower cost.

## Claims

1. A power supply box (1) used for completing one apparatus by connecting plural devices by the use of a connection power cable (7), comprising:
(1) a container case (11) having an inlet (4) for inserting said connection power cable (7),
(2) a power supply unit installed at a first position of the container case,
(3) a terminal (2, 3) installed at a second position of said container case, for mutually connecting said plural devices, and
(4) fixing means (5, 8) for fixing said terminal to said container case (11),
*characterized in that*
said terminal is only one of first terminal (2) and second terminal (3),
the length of said first terminal (2) in X direction is longer than the length of said second terminal (3) in X direction,
said fixing means possesses a first rib (5) for fixing said first terminal (2) installed integrally in said container case (11), and a second rib (8) for fixing said second terminal (3),
the end portion of said first terminal (2) or second terminal (3) in X direction is fitted and fixed to said first rib (5) or said second rib (8), said inlet (4), said first rib (5), and the second rib (8) are arranged nearly in series in Y direction orthogonal to said X direction,
said first rib (5) is installed closer to said inlet than said second rib (8), and
only one of said first terminal (2) and said second terminal (3) is fixed in said container case (11).

2. A power supply box of claim 1, wherein said second rib (8) is positioned outside of the width of said second terminal (3) in X direction, in a side view as seen from said inlet, when said second terminal (3) is fixed in said second rib (8).

3. A power supply box of claim 1, wherein said first terminal (2) and said second terminal (3) are nearly in a form of rectangular parallelepiped, said first rib has at least two ribs (5) confronting each other, and the mutually confronting end portions of said first terminal (2) are fitted and fixed in said two ribs (5).

4. A power supply box of claim 1, wherein said first terminal (2) and said second terminal (3) are nearly in a form of rectangular parallelepiped, said second rib has at least two ribs (8) confronting each other, and the mutually confronting end portions of said second terminal (3) are fitted and fixed in said two ribs (8).

5. A power supply box of claim 1, wherein said one apparatus is an air-conditioner, and said plural devices are an outdoor unit and an indoor unit.

6. A power supply box of claim 5, wherein said power supply unit comprises electronic components for controlling electric functions of said outdoor unit and indoor unit.

7. A power supply box of claim 1, wherein when said connection power cable (7) is a stranded wire connection power cable composed of stranded wires, said second terminal can connect said stranded wire connection power cable, and when said connection power cable is a single wire connection power cable composed of a single wire, said first terminal (2) can connect said single wire connection power cable.

8. A power supply box of claim 1, wherein said first rib (5) and said second rib (8) possess a pawl shape, and said first terminal (2) and said second terminal (3) are fixed by the pawl shape.

9. A power supply box of claim 1, wherein said first rib (5) and said second rib (8) are manufactured by resin molding integrally with said container case (11).

10. A power supply box of claim 1, further comprising a third rib, wherein said third rib is installed between said first rib (5) and said second rib (8), a third terminal can be connected to said third rib, and the length of third terminal in X direction is shorter than the length of said first terminal (2) in X direction, and longer than the length of said second terminal (3) in X direction.

11. A power supply box of claim 1, wherein plural ribs are installed instead of said first rib (5) and said second rib (8), each rib of said plural ribs for fixing can be connected with only one of plural terminals mutually different in the length in X direction, and each rib of said plural ribs is installed so that the terminal having the longest length in X direction out of said plural terminals can be fixed at the position closest to said inlet, that the terminal having the shortest length in X direction can be fixed at the position remotest from said inlet, and that terminals having smaller length in X direction can be connected as going remoter from said inlet.

## Patentansprüche

1. Energieversorgungsbox (1), die zum Komplettieren einer Vorrichtung benutzt wird, indem mehrere Geräte unter Verwendung eines Energiekopplungskabels (7) verbunden werden, umfassend:
(1) ein Containergehäuse (11), das über einen Eingang (4) für das Einführen des Energiekopplungskabels (7) verfügt,
(2) eine Energieversorgungseinheit, die in einer ersten Position des Containergehäuses installiert ist,
(3) ein Terminal (2,3), das zur wechselseitigen Verbindung der mehreren Geräte in einer zweiten Position des Containergehäuses installiert ist, und
(4) Befestigungshilfsmittel (5,8) zur Befestigung des Terminals an dem Containergehäuse (11),
dadurch gekennzeichnet, dass
das Terminal nur eines von einem ersten Terminal (2) und einem zweiten Terminal (3) ist,
die Länge des ersten Terminals (2) in x- Richtung größer ist als die Länge des zweiten Terminals in x- Richtung,
die Befestigungshilfsmittel über eine erste Rippe (5) zur Befestigung des ersten Terminals (2), das völlig in dem Containergehäuse (11) eingebaut ist, und über eine zweite Rippe (8) zur Befestigung des zweiten Terminals (3) verfügen,
das Endteil des ersten Terminals (2) oder des zweiten Terminals (3) in x- Richtung eingepasst ist und an der ersten Rippe (5) oder an der zweiten Rippe (8) befestigt wird, der Eingang (4), die erste Rippe (5) und die zweite Rippe (8) annähernd in einer Reihe in y- Richtung senkrecht zu der x-Richtung angeordnet sind,
die erste Rippe (5) näher zu dem Eingang als die zweite Rippe (8) eingebaut ist, und
nur einer von dem ersten Terminal (2) und dem zweiten Terminal (3) in dem Containergehäuse (11) befestigt ist.

2. Energieversorgungsbox nach Anspruch 1, dadurch gekennzeichnet, dass die zweite Rippe (8) - in einer Seitenansicht von dem Eingang aus betrachtet - außerhalb der lichten Weite des zweiten Terminals (3) in x- Richtung angeordnet ist, wenn das zweite Terminal (3) an der zweiten Rippe (8) befestigt ist.

3. Energieversorgungsbox nach Anspruch 1, dadurch gekennzeichnet, dass das erste Terminal (2) und das zweite Terminal (3) nahezu die Form eines rechtwinkligen Parallelepipeds haben, wobei die erste Rippe mindestens zwei einander gegenüberliegende Rippen (5) hat und die einander gegenüberliegenden Endteile des ersten Terminals (2) an den zwei Rippen (5) eingepasst und befestigt sind.

4. Energieversorgungsbox nach Anspruch 1, dadurch gekennzeichnet, dass das erste Terminal (2) und das zweite Terminal (3) nahezu die Form eines rechtwinkligen Parallelepipeds haben, wobei die zweite Rippe mindestens zwei einander gegenüberliegende Rippen (8) hat und die einander gegenüberliegenden Endteile des zweiten Terminals (3) an den zwei Rippen (8) eingepasst und befestigt sind.

5. Energieversorgungsbox nach Anspruch 1, dadurch gekennzeichnet, dass die eine Vorrichtung eine Klimaanlage ist und die mehreren Geräte eine Außeneinheit und eine Inneneinheit sind.

6. Energieversorgungsbox nach Anspruch 5, dadurch gekennzeichnet, dass die Energieversorgungseinheit elektronische Komponenten zur Steuerung der elektrischen Funktionen der Außeneinheit und der Inneneinheit umfasst.

7. Energieversorgungsbox nach Anspruch 1, dadurch gekennzeichnet, dass im Falle, dass das Energiekopplungskabel (7) ein aus Litzendraht zusammengesetztes Litzendraht-Energiekopplungskabel ist, das zweite Terminal das Litzendrahten-Ergiekopplungskabel anschließen kann, und im Falle, dass das Energiekopplungskabel ein aus einem Einfachdraht bestehendes Einfachdraht-Energiekopplungskabel ist, das erste Terminal (2) das Einfachdraht-Energiekopplungskabel anschließen kann.

8. Energieversorgungsbox nach Anspruch 1, dadurch gekennzeichnet, dass die erste Rippe (5) und die zweite Rippe (8) eine Klinkenform besitzen und das erste Terminal (2) und das zweite Terminal (3) von der Klinkenform befestigt werden.

9. Energieversorgungsbox nach Anspruch 1, dadurch gekennzeichnet, dass die erste Rippe (5) und die zweite Rippe (8) aus durch Kunstharzformung integral mit dem Containergehäuse (11) hergestellt sind.

10. Energieversorgungsbox nach Anspruch 1, die ferner eine dritte Rippe enthält, dadurch gekennzeichnet, dass die dritte Rippe zwischen der ersten Rippe (5) und der zweiten Rippe (8) angebracht ist, und wobei ein drittes Terminal mit der dritten Rippe verbunden werden kann und die Länge des dritten Terminals in x- Richtung kürzer ist als die Länge des ersten Terminals (2) in x- Richtung, jedoch länger ist als die Länge des zweiten Terminals in x- Richtung.

11. Energieversorgungsbox nach Anspruch 1, dadurch gekennzeichnet, dass mehrere Rippen an Stelle der ersten Rippe (5) und der zweiten Rippe (8) eingebaut sind, wobei jede Rippe der mehreren Befestigungsrippen nur mit einem der mehreren Terminals, die sich voneinander in ihren Längen in x- Richtung unterscheiden, verbunden werden kann, und wobei jede Rippe der mehreren Rippen so eingebaut ist, dass das Terminal mit der größten Länge in x-Richtung von den mehreren Terminals an der Position befestigt werden kann, die dem Eingang am nächsten ist, dass das Terminal mit der kürzesten Länge in x- Richtung an der Position befestigt werden kann, die von dem Eingang am weitesten entfernt ist, und dass Terminals mit kleineren Längen in x- Richtung so angeschlossen werden können, wie sie sich von dem Eingang weiter entfernen.

## Revendications

1. Boîtier d'alimentation électrique (1) utilisé pour réaliser un appareil en reliant une pluralité de dispositifs par l'utilisation d'un câble électrique de liaison (7), comprenant :
(1) un coffret (11) présentant un passage (4) destiné à insérer ledit câble électrique de liaison (7),
(2) une unité d'alimentation électrique disposée au niveau d'un premier emplacement du coffret,
(3) un bornier (2, 3) disposé au niveau d'un second emplacement dudit coffret, destiné à relier mutuellement ladite pluralité des dispositifs, et
(4) un moyen de fixation (5, 8) destiné à fixer ledit bornier audit coffret (11),
*caractérisé en ce que*
ledit bornier est seulement l'un d'un premier bornier (2) et d'un second bornier (3),
la longueur dudit premier bornier (2) dans la direction X est plus longue que la longueur dudit second bornier (3) dans la direction X,
ledit moyen de fixation possède une première patte (5) destinée à fixer ledit premier bornier (2) disposé de façon intégrée dans ledit coffret (11), et une seconde patte (8) destinée à fixer ledit second bornier (3),
la partie d'extrémité dudit premier bornier (2) ou dudit second bornier (3) dans la direction X est adaptée et fixée à ladite première patte (5) ou à ladite seconde patte (8), ledit passage (4), ladite première patte (5) et la seconde patte (8) sont agencés pratiquement en série dans la direction Y orthogonale à ladite direction X,
ladite première patte (5) est disposée plus près dudit passage que ladite seconde patte (8), et
seul l'un dudit premier bornier (2) et dudit second bornier (3) est fixé dans ledit coffret (11).

2. Boîtier d'alimentation électrique selon la revendication 1, dans lequel ladite seconde patte (8) est disposée à l'extérieur de la largeur dudit second bornier (3) dans la direction X, en vue latérale observée depuis ledit passage, alors que le second bornier (3) est fixé dans ladite seconde patte (8).

3. Boîtier d'alimentation électrique selon la revendication 1, dans lequel ledit premier bornier (2) et ledit second bornier (3) sont pratiquement sous la forme d'un parallélépipède rectangle, ladite première patte comporte au moins deux pattes (5) se faisant face l'une l'autre, et les parties d'extrémité se faisant face mutuellement dudit premier bornier (2) sont adaptées et fixées auxdites deux pattes (5).

4. Boîtier d'alimentation électrique selon la revendication 1, dans lequel ledit premier bornier (2) et ledit second bornier (3) sont pratiquement sous la forme d'un parallélépipède rectangle, ladite seconde patte comporte au moins deux pattes (8) se faisant face l'une l'autre, et les parties d'extrémité se faisant mutuellement face dudit second bornier (3) sont adaptées et fixées dans lesdites deux pattes (8).

5. Boîtier d'alimentation électrique selon la revendication 1, dans lequel ledit un appareil est un conditionneur d'air, et ladite pluralité de dispositifs sont une unité extérieure et une unité intérieure.

6. Boîtier d'alimentation électrique selon la revendication 5, dans lequel ladite unité d'alimentation électrique comprend des composants électroniques destinés à commander les fonctions électriques de ladite unité extérieure et de ladite unité intérieure.

7. Boîtier d'alimentation électrique selon la revendication 1, dans lequel, lorsque ledit câble électrique de liaison (7) est un câble électrique de liaison à brins multiples constitué de brins multiples, ledit second bornier peut connecter ledit câble électrique de liaison à brins multiples, et lorsque ledit câble électrique de liaison est un câble électrique de liaison à fil unique constitué d'un fil unique, ledit premier bornier (2) peut connecter ledit câble électrique de liaison à fil unique.

8. Boîtier d'alimentation électrique selon la revendication 1, dans lequel ladite première patte (5) et ladite seconde patte (8) possèdent une forme de cliquet, et ledit premier bornier (2) et ledit second bornier (3) sont fixés grâce à la forme de cliquet.

9. Boîtier d'alimentation électrique selon la revendication 1, dans lequel ladite première patte (5) et ladite seconde patte (8) sont fabriquées par moulage de résine de façon intégrée audit coffret (11).

10. Boîtier d'alimentation électrique selon la revendication 1, comprenant en outre une troisième patte, dans lequel ladite troisième patte est disposée entre ladite première patte (5) et ladite seconde patte (8), un troisième bornier peut être relié à ladite troisième patte, et la longueur du troisième bornier dans la direction X est plus courte que la longueur dudit premier bornier (2) dans la direction X, et plus longue que la longueur dudit second bornier (3) dans la direction X.

11. Boîtier d'alimentation électrique selon la revendication 1, dans lequel plusieurs pattes sont disposées à la place de ladite première patte (5) et de ladite seconde patte (8), chaque patte desdites plusieurs pattes destinées à fixer peut être reliée avec un seul de plusieurs borniers mutuellement différents en longueur dans la direction X, et chaque patte desdites plusieurs pattes est disposée de manière à ce que le bornier présentant la longueur la plus longue dans la direction X parmi lesdits plusieurs borniers puisse être fixé au niveau de la position la plus proche dudit passage, que le bornier présentant la longueur la plus courte dans la direction X puisse être fixé au niveau de l'emplacement le plus éloigné dudit passage, et que les borniers présentant une longueur plus petite dans la direction X puissent être reliés à mesure qu'ils s'éloignent dudit passage.
